# EUROPEAN PATENT APPLICATION

(11) **EP 1 168 658 A1**
(43) Date of publication of application: **02.01.2002**
(21) Application number: 00900181.9
(22) Date of filing: 11.01.2000
(51) Int. Cl.: H04B 7/08, H03H 7/48, H03H 7/38, H01Q 21/24, H01Q 3/24

(54) **MOBILE RADIO UNIT**

(71) Applicant: MITSUBISHI DENKI KABUSHIKI KAISHA, Tokyo 100-8310 (JP)
(72) Inventor: SHOJI, Hideaki, Mitsubishi Denki Kabushiki Kaisha, Tokyo 100-8310 (JP); IMANISHI, Yasuhito, Mitsubishi Denki Kabushiki K., Tokyo 100-8310 (JP); FUKASAWA, Toru, Mitsubishi Denki Kabushiki Kaisha, Tokyo 100-8310 (JP); OHMINE, Hiroyuki Mitsubishi Denki Kabushiki Kaisha, Tokyo 100-8310 (JP)
(74) Representative: Sajda, Wolf E., Dipl.-Phys.
(86) International application number: JP0000090
(87) International publication number: WO0152445

(57) **Abstract**

In a cabinet (3) of portable radio equipment, two transmitting/receiving antennas (1, 2) are placed orthogonal to each other. These transmitting/receiving antennas (1, 2) are connected via a power distributor (5) to a radio unit (4). A tilt angle detector (9) detects the tilt of the cabinet (3). A control circuit (10) controls impedance transformation circuits (6, 7), based on the detected tilt angle, to alter the weighting of a distribution ratio of power being fed to the respective antennas. A composite impedance adjustment circuit (8) adjusts total composite impedance of the transmitting/receiving antennas (1, 2) and the radio unit (4).

## Description

### Technical Field

The present invention relates to portable radio equipment, and more particularly, to portable radio equipment communicating with a base station that uses an antenna having one main plane of polarization.

### Background Art

As transmitting/receiving antennas for use in portable radio equipment, a whip antenna attached to a cabinet in the longitudinal direction and a helical antenna are known. Of the antennas for portable radio equipment commercially available at present in Japan, the one of a whip and helical type is often utilized, which operates as a whip antenna when pulled out, and a helical antenna provided at the end of the whip antenna via an insulator comes to work when retracted. An inverted F antenna or the like is built in the cabinet as an antenna for reception diversity.

Generally, one of the causes that would degrade characteristics of an antenna is antenna efficiency, which is determined from an effective radiation area according to the physical size and structure of the antenna. Others include loss due to impedance mismatch with a radio unit and loss due to nonconformity of directivity and plane of polarization with an antenna as a counterpart in communication.

An antenna on the mobile terminal side of the mobile communication like the portable radio equipment is placed or held in different environments as the terminal moves, so that directivity and plane of polarization thereof change constantly. In addition, since such equipment is often employed near a human body, it tends to be affected by the human body nearby.

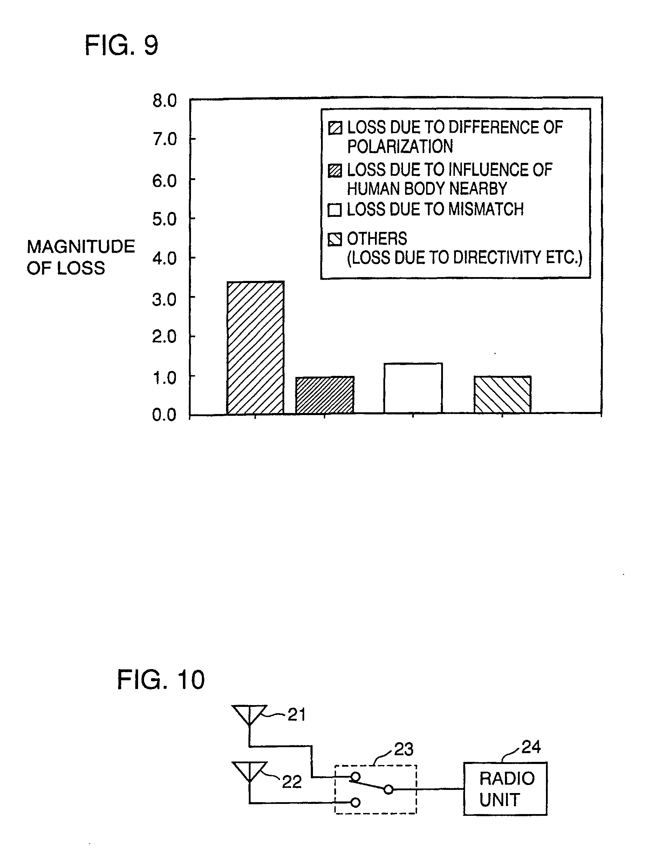

Fig. 9 shows exemplary details of loss of gain averaged through the horizontal plane during a call of portable radio equipment provided with a whip antenna attached to the metal cabinet. As seen from Fig. 9, compared to the loss due to the influence of the adjacent human body or due to mismatch, the loss due to the difference of polarization is considerably large.

An antenna at the base station that communicates with the portable radio equipment has, as its main polarization, vertical polarization with respect to the land surface. Although the waves transmitted from the transmitting/receiving antenna of the base station repeat reflection and diffraction due to buildings and other structures until they reach the receiving antenna of the portable radio equipment, it is known that the main polarization of the waves transmitted from the base station to the portable radio equipment is generally the vertical polarization. Regarding the reception characteristic of the transmitting/receiving antenna at the base station, it is obvious, from the reversibility of the transmission/reception characteristics of an antenna, that the antenna gain will increase as the vertically polarized wave components in the waves coming from the portable radio equipment are more dominant.

The whip antennas and others placed on the portable radio equipment have various kinds of radiation patterns according to electrical lengths of the antenna elements and sizes of the cabinets. However, it is known that, when the portable radio equipment is placed in an upright position, the main polarization becomes vertical to the land surface.

Thus, when portable radio equipment is being used for communication (often tilted at about 60 degrees from a zenithal direction) or placed horizontally on a desk or the like, the main polarization of the antenna formed in the portable radio equipment comes to considerably deviate from the main polarization of the antenna at the base station that is vertical to the land surface. This causes degradation of antenna gain.

Techniques to reduce the loss due to such nonconformity of polarization have conventionally been proposed. An example thereof, for a receiving antenna, is a technique to realize reception diversity, in which an antenna having vertical polarization as its main polarization, such as a whip antenna, and a receive-only built-in antenna having horizontally polarized wave components, such as an inverted F antenna, are switched with each other.

Fig. 10 shows a configuration for the reception diversity in conventional portable radio equipment. Referring to Fig. 10, a transmitting/receiving antenna 21 and a built-in antenna 22 having main polarization different in direction from that of transmitting/receiving antenna 21 are provided. Transmitting/receiving antenna 21 and built-in antenna 22 are switched using a changeover switch 23, and either transmitting/receiving antenna 21 or built-in antenna 22 is connected via changeover switch 23 to a radio unit 24.

Assume that transmitting/receiving antenna 21 and built-in antenna 22 are receiving waves from the base station. As these two antennas are placed a prescribed distance apart from each other and have main polarization of different directions, the reception characteristics of these antennas change due to fading and others over time, with a prescribed correlation. In radio unit 24, control is performed to switch changeover switch 23 to either transmitting/receiving antenna 21 or built-in antenna 22 that exhibits a better reception characteristic during a certain period of time. Such control guarantees a more stable reception characteristic.

In the configuration shown in Fig. 10, if an inverted F antenna is employed as the receive-only antenna, it is difficult to provide a sufficiently large bottom board on the portable radio equipment. Thus, in the radiation pattern of the inverted F antenna, radiation from the longitudinal direction of the metal portion of the cabinet becomes dominant. As a result, the directivity and the direction of main polarization of the inverted F antenna come to approximate to those of the whip antenna, so that it becomes difficult to ensure adequate correlation of polarization between the antennas. In order to solve such a problem, one technique employs a microstrip antenna or a circularly polarized wave receiving antenna as the built-in antenna to increase the recognition level of cross polarization with the whip antenna.

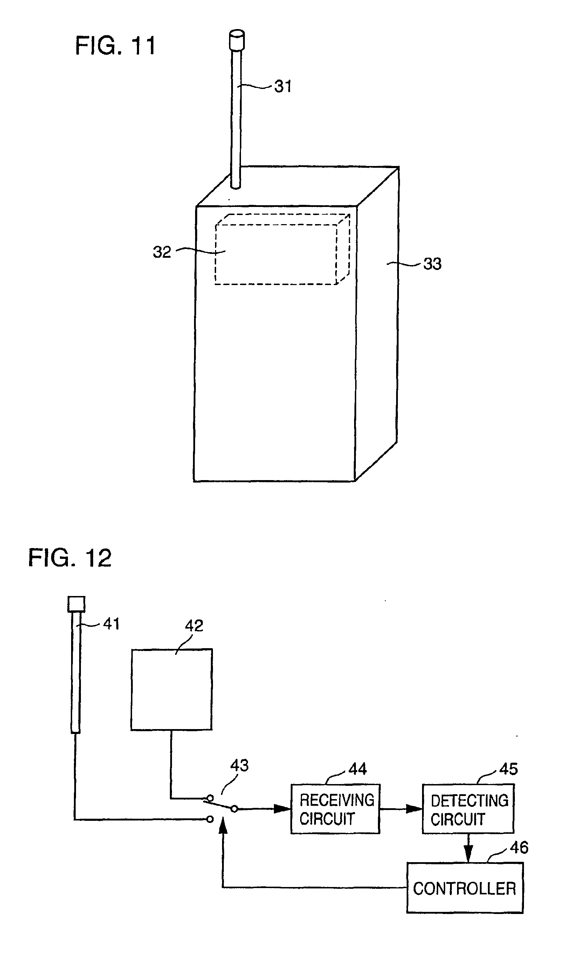

Fig. 11 shows a built-in antenna for reception diversity of portable radio equipment disclosed, for example, in Japanese Patent Laying-Open No. 6-338816. Referring to Fig. 11, an external antenna 31 and a built-in antenna 32 formed of one-side short-circuited type microstrip that is different in direction of main polarization and directivity from the external antenna 31 are built in a cabinet 33 of portable radio equipment. Since the direction of main polarization and directivity of external antenna 31 are different from those of built-in antenna 32, it becomes possible to increase the coefficient of correlation between the antennas, so that effective diversity is enabled.

Fig. 12 shows an example to improve the reception characteristic of portable radio equipment disclosed, for example, in Japanese Patent Laying-Open No. 6-188801. Referring to Fig. 12, an antenna 41 for linear polarization for use in receiving the linear polarization and an antenna 42 for circular polarization for use in receiving the circular polarization are provided. At the time of reception, antenna 42 for circular polarization waits for radio waves. When a detecting circuit 42 detects reception of desired radio waves, a controller 46 controls a changeover switch 43 to switch the reception antenna from antenna 42 for circular polarization to antenna 41 for linear polarization for use in transmission/reception. In this configuration, antenna 42 for circular polarization is used when receiving the radio waves. Thus, regardless of the direction in which the terminal is directed, degradation of antenna gain due to nonconformity of polarization can be decreased.

The examples described above are directed to improve the reception diversity characteristics. They do not attempt to decrease the loss due to nonconformity of polarization to improve the transmission characteristics of the portable radio equipment. To improve the transmission/reception characteristics by decreasing such loss due to nonconformity of polarization, the antenna may be mechanically inclined with respect to the cabinet.

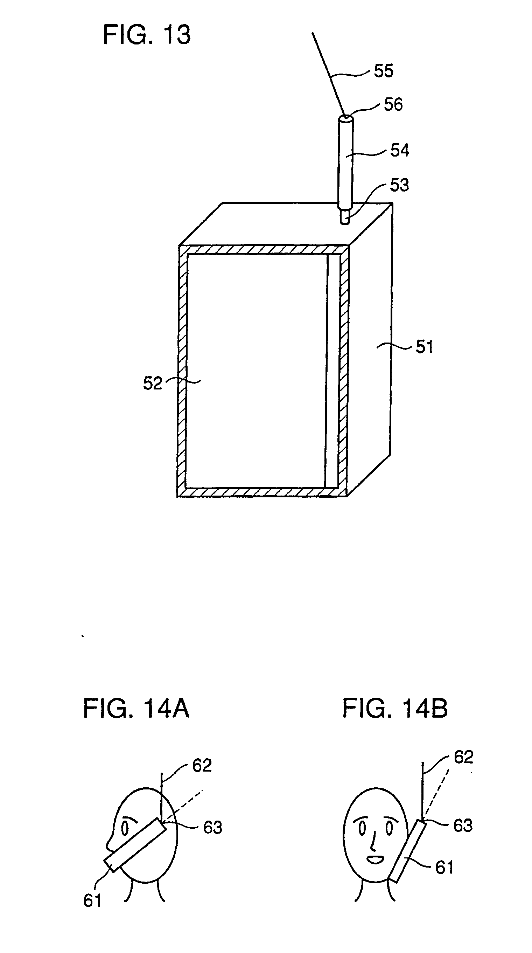

Fig. 13 shows such an example disclosed in Japanese Patent Laying-Open No. 8-274525. Radio waves are fed from a metal cabinet 52 covered with a resin cabinet 51 through a coaxial line 53 to an antenna 54. An outer sheath of the upper portion of coaxial line 53 is connected with a cylindrical choke 54 having an electrical length of λ/4, so that, together with antenna 55, the performance equivalent to that of a λ/2 dipole antenna can be obtained. At this time, the antenna is held in an erect position by means of a rotatable joint 56 regardless of the attitude of the portable radio equipment, and accordingly, the gain degradation of the transmission/reception characteristics due to nonconformity of polarization with the base station can be reduced.

Figs. 14A and 14B show an antenna 62 disclosed in Japanese Patent Laying-Open No. 6-268547, which is provided with a joint 63 so that, when antenna 62 is pulled out from a cabinet 61 of portable radio equipment, it is made perpendicular to the land surface. Thus, the gain degradation of the transmission/reception characteristics due to nonconformity of polarization with the base station is decreased.

These antennas, however, require structures for mechanical inclination thereof. In addition, a user of the portable radio equipment needs to adjust the angle of the antenna. Since the angle to which the antenna can be inclined is limited to a certain extent, the antenna may become a nuisance to the user when calling.

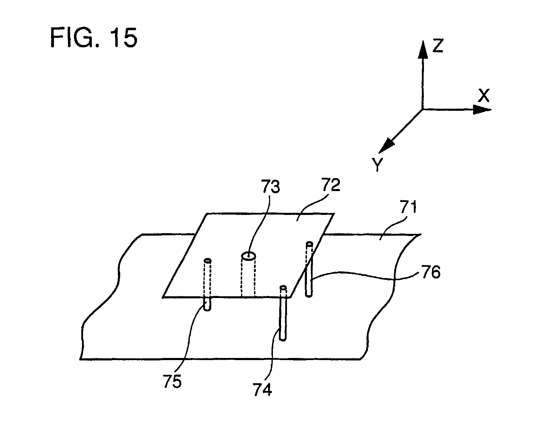

There is another way to switch the polarization by switching short-circuited points according to the attitude of the portable radio equipment. Fig. 15 shows an antenna portion of the configuration disclosed in Japanese Patent Laying-Open No. 2-94713. Referring to Fig. 15, a plate antenna 72 is provided on the bottom board 71, and radio waves are fed from an antenna feed point 73 to this plate antenna 72. Plate antenna 72 is placed on bottom board 71 by means of a short-circuited point 74 and short-circuited points 75 and 76 with changeover switches. Thus, even in a single antenna, changeover switches of short-circuited points 75 and 76 can be switched to change the direction of main polarization of the antenna, so that the gain deterioration due to nonconformity of polarization can be decreased.

This method has an advantage that polarization can be switched in one antenna. However, it has a disadvantage, as in the case of the inverted F antenna described above, that the bottom board of an adequate size cannot be ensured on the portable radio equipment, and thus, a sufficient recognition level of cross polarization cannot be obtained. In addition, it is difficult to direct the main polarization in a direction orthogonal to the plate antenna that is shown as the Z direction in Fig. 15.

The transmitting/receiving waves from an antenna of portable radio equipment that is placed or held in any direction are likely to diverge in direction of main polarization from that of the antenna at the base station whose main polarization is vertical to the land surface, thereby causing loss. When a simple linear antenna is being utilized, the antenna needs to be inclined to realize the vertical polarization. This requires a certain mechanical structure, and further, the inclined antenna may cause discomfort of a user while he/she calls. Further, in the case where the direction of main polarization of one plate antenna is switched by switching short-circuited points, it is difficult to achieve a sufficient recognition level of cross polarization. There also exists a certain direction in which the main polarization cannot be directed with ease.

### Disclosure of the Invention

Based on the foregoing, a primary object of the present invention is to provide portable radio equipment that can be fitted to plane of polarization of waves transmitted to or received from a base station, and that can electrically reduce loss due to nonconformity of polarization regardless of the direction in which the portable radio equipment is placed or held.

The present invention is directed to portable radio equipment provided with a radio unit formed of a transmitting/receiving circuit within a cabinet. It includes at least two transmitting/receiving antennas different in direction of main polarization from each other, and a power distributor that couples the respective antennas to the radio unit to cause the at least two transmitting/receiving antennas to operate simultaneously and that weights distribution amounts of power being dealt by the respective antennas.

Preferably, the portable radio equipment is further provided with a tilt detector for detection of a tilt angle of the cabinet, and a control circuit for controlling, based on the detected tilt angle, power distribution by the power distributor so as to optimize transmission/reception of the at least two transmitting/receiving antennas.

Still preferably, the portable radio equipment is further provided with a reception strength detector for detection of received field strength of each of the at least two transmitting/receiving antennas, a comparator for comparison of the detected received field strength with the weighting of the antenna given by the power distributor, and a control circuit for controlling, based on the comparison output of the comparator, the weighting of the power distributor so as to optimize a ratio of the power being fed to the respective antennas.

The power distributor includes an impedance transformation circuit that controls impedance of the at least two transmitting/receiving antennas to change the weighting of the distribution ratio of the power being fed to the respective antennas, and an impedance adjustment circuit that adjusts total composite impedance of the at least two transmitting/receiving antennas and the radio unit.

The impedance transformation circuit and the impedance adjustment circuit are formed of variable capacitance diodes.

Preferably, the at least two transmitting/receiving antennas are placed in directions orthogonal to each other.

Still preferably, one of the at least two transmitting/receiving antennas is a whip antenna, and the rest of the antennas includes a meander antenna that is folded to meander so as to reduce the total length.

### Brief Description of the Drawings

Fig. 1 is a diagram showing a schematic view of portable radio equipment according to a first embodiment of the present invention.
Fig. 2 is a block diagram of the portable radio equipment according to the first embodiment of the present invention.
Fig. 3 is a diagram showing specific examples of the impedance transformation circuits and the composite impedance matching circuit shown in Fig. 2.
Fig. 4 is a diagram showing a schematic view of portable radio equipment according to a second embodiment of the present invention.
Fig. 5 is a block diagram of the portable radio equipment according to the second embodiment of the present invention.
Fig. 6 is a diagram showing a schematic view of portable radio equipment according to a third embodiment of the present invention.
Fig. 7 is a diagram showing a schematic view of portable radio equipment according to a fourth embodiment of the present invention.
Fig. 8 is a block diagram of the portable radio equipment according to a fifth embodiment of the present invention.
Fig. 9 is a diagram showing exemplary details of loss of gain averaged through the horizontal plane during a call of portable radio equipment.
Fig. 10 is a schematic block diagram of conventional portable radio equipment employing a changeover reception diversity method.
Fig. 11 is a diagram showing a schematic view of conventional portable radio equipment employing the changeover reception diversity method to reduce loss due to nonconformity of polarization.
Fig. 12 is a block diagram of conventional portable radio equipment.
Fig. 13 is a diagram showing a schematic view of conventional portable radio equipment having an antenna mechanically inclined to reduce loss due to mismatch of polarization.
Figs. 14A and 14B are diagrams illustrating a conventional example to reduce the loss due to nonconformity of polarization by mechanically inclining the antenna.
Fig. 15 is a diagram illustrating a conventional example to improve transmission/reception characteristics in a single antenna by switching the direction of main polarization.

### Best Modes for Carrying Out the Invention

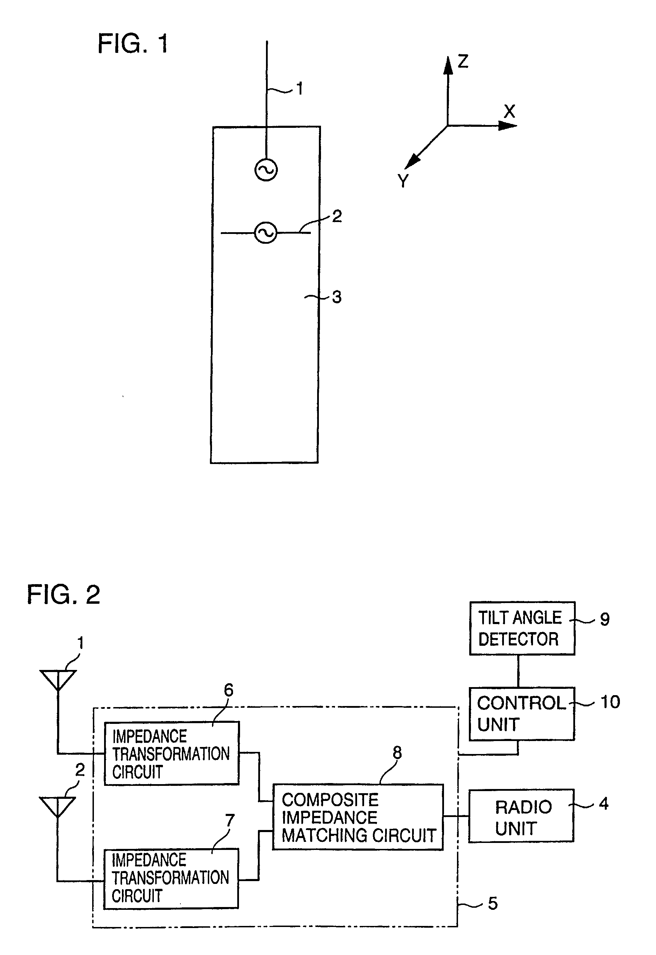

Fig. 1 schematically shows portable radio equipment of the first embodiment of the present invention. Fig. 2 is a block diagram thereof.

Referring to Fig. 1, transmitting/receiving antennas 1 and 2, different in direction of main polarization from each other, are attached to a cabinet 3 of the portable radio equipment. Transmitting/receiving antennas 1 and 2 are placed orthogonal to each other. As the transmitting/receiving antenna 1, a whip antenna is employed, which is pulled out upwards from cabinet 3. Transmitting/receiving antenna 2 is contained within cabinet 3 to extend in a horizontal direction. Since the directions of the electric fields transmitted/received through transmitting/receiving antennas 1 and 2 are orthogonal to each other, antenna coupling can be made small. The coefficient of correlation between these antennas can be made large, so that the recognition level of cross polarization can also be increased.

As shown in Fig. 2, transmitting/receiving antennas 1 and 2 are each connected directly to a variable power distributor 5 being connected to a radio unit 4. Variable power distributor 5 is formed of impedance transformation circuits 6 and 7 that are connected to transmitting/receiving antennas 1 and 2, respectively, and a composite impedance matching circuit 8. Impedance transformation circuits 6 and 7 are used to change the weighting of a distribution ratio of the power being fed to transmitting/receiving antennas 1 and 2. Composite impedance matching circuit 8 is used to adjust the total composite impedance of two transmitting/receiving antennas 1, 2 and radio unit 4.

A tilt angle detector 9, such as a gravity direction sensor, is further provided for detection of the tilt angle of cabinet 3. The detected output of this tilt angle detector 9 is supplied to a control unit 10. Based on the detected output of tilt angle detector 9, control circuit 10 controls impedance transformation circuits 6, 7 within variable power distributor 5, and changes the weighting of the distribution ratio of the power to be fed to transmitting/receiving antennas 1 and 2. Control circuit 10 also controls composite impedance matching circuit 8 at the same time, so that the composite impedance of impedance transformation circuits 6, 7 is matched to characteristic impedance to radio unit 4 seen from the antennas.

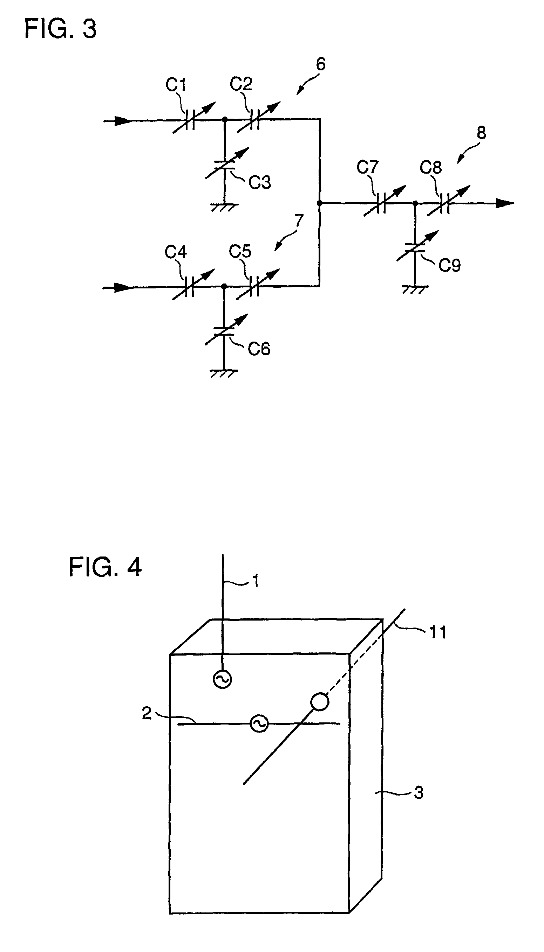

Impedance transformation circuits 6, 7 and composite impedance matching circuit 8 are formed of variable capacitance diodes C1-C9, as shown in Fig. 3. More specifically, impedance transformation circuit 6 is formed with variable capacitance diodes C1 and C2 serially connected with each other, and another variable capacitance diode C3 that is connected between a connect point of variable capacitance diodes C1, C2 and a ground node. Similarly, impedance transformation circuit 7 is formed with variable capacitance diodes C4 and C5 that are serially connected with each other, and another variable capacitance diode C6 that is connected between a connect point of variable capacitance diodes C4, C5 and a ground node. Composite impedance matching circuit 8 is formed of variable capacitance diodes C7 and C8 that are serially connected with each other, and another variable capacitance diode C9 that is connected between a connect point of variable capacitance diodes C7, C8 and a ground node.

These variable capacitance diodes C1-C9 are provided with a prescribed level of voltage as a control signal from control unit 10. The capacitance is altered according to this voltage, so that the impedance is changed.

As described above, according to the present embodiment, transmitting/receiving antennas 1 and 2 are placed orthogonal to each other. Thus, the antenna coupling can be made small, and the coefficient of correlation between transmitting/receiving antennas 1 and 2 can be made large. Accordingly, the recognition level of cross polarization can be increased.

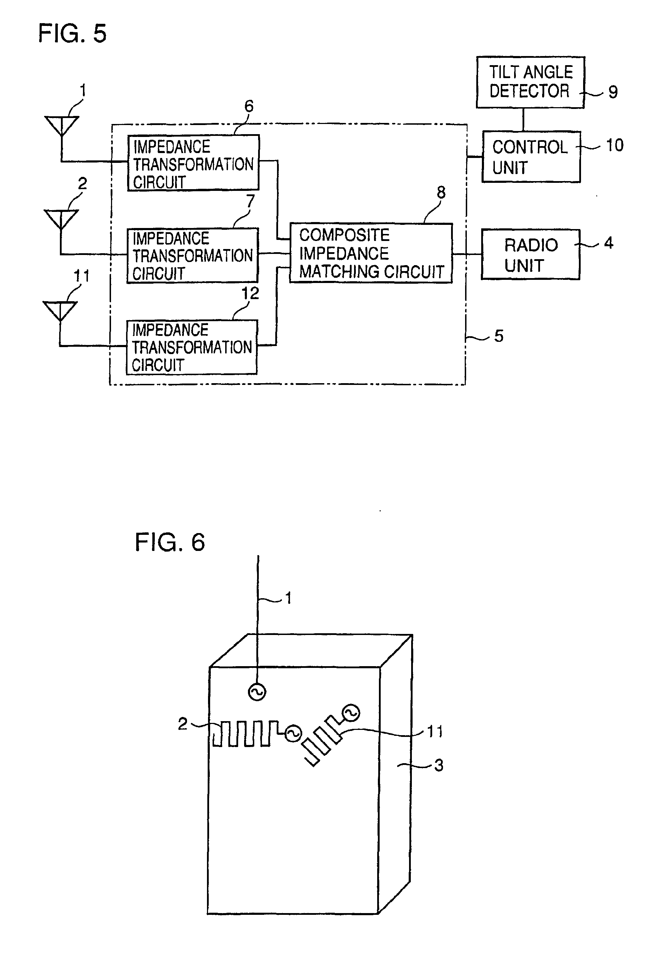

Fig. 4 schematically shows portable radio equipment of the second embodiment of the present invention. Fig. 5 is a block diagram thereof.

In the first embodiment shown in Figs. 1 and 2, first and second transmitting/receiving antennas 1 and 2 have been employed. In such a case, it is difficult to direct the main polarization in a direction (Y direction in Fig. 1) orthogonal to the electric fields of these transmitting/receiving antennas 1 and 2.

Thus, as shown in Fig. 4, three transmitting/receiving antennas 1, 2 and 11 are placed orthogonal to each other. By placing the respective antennas 1, 2 and 11 in a direction orthogonal to the electric fields being transmitted/received through the antennas, it is possible to control such that the composed plane of polarization of the three antennas has vertical polarization with respect to the land surface, regardless of the direction in which the portable terminal is placed.

Corresponding to additionally provided transmitting/receiving antenna 11, an additional impedance transformation circuit 12 is provided within variable power distributor 5. Control unit 10 controls impedance transformation circuits 6, 7 and 12, as in the first embodiment, to change the weighting of a distribution ratio of the power being fed to the respective antennas. Composite impedance matching circuit 8 adjusts the total composite impedance of these three transmitting/receiving antennas 1, 2 and 11 and radio unit 4.

Thus, by providing three antennas 1, 2 and 11, the composed plane of polarization of the three antennas can be controlled to have vertical polarization with respect to the land surface regardless of the direction in which the portable terminal is placed.

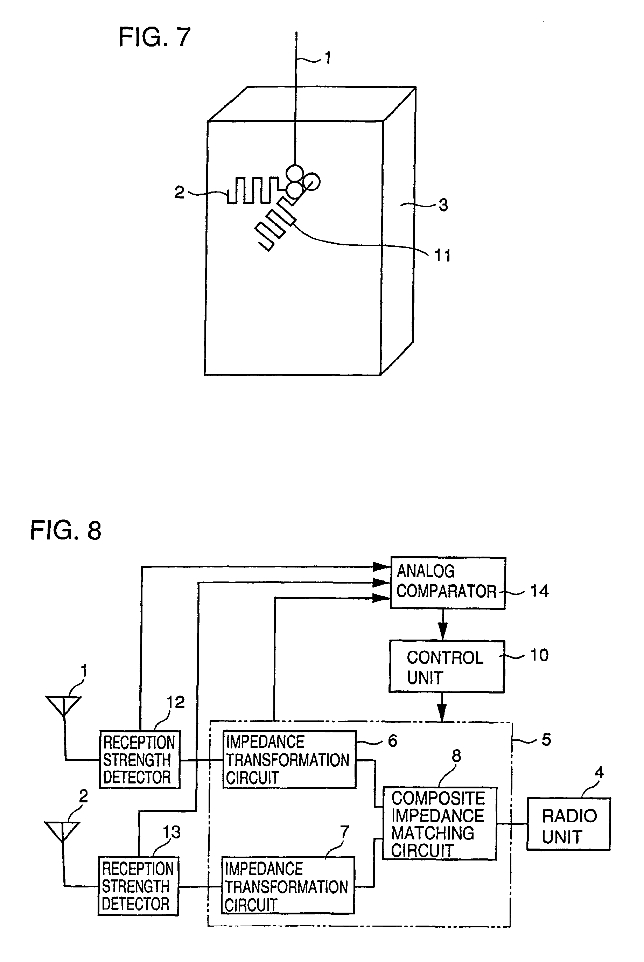

Figs. 6 and 7 schematically show the third and fourth embodiments of the present invention, respectively.

The second embodiment shown in Fig. 4 is increased in the outside dimension, as it is provided with three transmitting/receiving antennas 1, 2 and 11. Thus, in Fig. 6, other than transmitting/receiving antenna 1 formed of a whip antenna, two transmitting/receiving antennas 2 and 11 are each formed of a meander type antenna that is folded to reduce the total length, or of a helical type antenna not shown.

Further, if the feed points of respective transmitting/receiving antennas 1, 2 and 11 are placed close to each other, as shown in Fig. 7, the antenna coupling can be made smaller, and therefore, the recognition level of cross polarization can further be improved.

Fig. 8 is a block diagram of portable radio equipment according to the fifth embodiment of the present invention.

In the embodiments shown in Figs. 2 and 5, tilt angle detector 9 has been provided, and the distribution ratio of power being fed to the respective antennas has been controlled based on the detected tilt angle. In the embodiment shown in Fig. 8, the distribution ratio of power being fed to the respective antennas is calculated based on their reception levels. To that end, transmitting/receiving antennas 1 and 2 are connected to field strength detectors 12 and 13, respectively, and the received field strengths of the antennas are detected. The detected outputs of reception field strength detectors 12, 13 are supplied to an analog comparator 14. Analog comparator 14 has also been provided with weighting of the antennas from power distributor 5. Analog comparator 14 compares the magnitudes of the received field strengths and the weighting of the antennas, and determines which antenna is more effective in reception. The determined result is output to control unit 10 for feedback to the control of variable power distributor 5 in a next control time, so that the distribution amount of power to the antenna performing effective reception is increased. Repeating such control makes it possible to optimize the ratio of power being fed to respective antennas. In other words, the antenna efficiently performing reception is determined as an antenna having vertical polarization with respect to the land surface in its current position and state. The transmission/reception of the antennas is thus controlled.

As explained above, according to the present invention, at least two transmitting/receiving antennas are coupled to a radio unit so that they operate at the same time, and the weighting of distribution amount of power being dealt by each antenna is changed, so that the direction of the composed main polarization of the antennas can be matched to the plane of polarization of the waves transmitted to or received from the base station. Accordingly, it is possible to improve antenna gain by electrically decreasing loss due to nonconformity of polarization, regardless of the direction in which the portable radio equipment is placed or held.

The embodiments of the present invention have been described above in detail with reference to the drawings. However, the present invention is not limited to any of the embodiments, and many kinds of variations and modifications are allowed within the scope of the spirit of the present invention. The scope of the present invention is indicated by the scope of the claims as attached.

## Claims

1. Portable radio equipment provided with a radio unit (4) formed of a transmitting/receiving circuit within a cabinet, comprising:
at least two transmitting/receiving antennas (1, 2, 11) different in direction of main polarization from each other; and
a power distributor (5) coupling each said antenna to said radio unit such that said at least two transmitting/receiving antennas operate simultaneously and weighting distribution amounts of power being dealt by the respective antennas.

2. The portable radio equipment according to claim 1, further comprising:
a tilt detector (9) detecting a tilt angle of said cabinet; and
a control circuit (10) controlling power distribution by said power distributor based on the tilt angle detected by said tilt detector, such that said at least two transmitting/receiving antennas realize optimum transmission/reception.

3. The portable radio equipment according to claim 2, wherein
said power distributor includes
an impedance transformation circuit (6, 7, 12) controlling impedance of said at least two transmitting/receiving antennas to change weighting of a distribution ratio of power being fed to the respective antennas, and
an impedance adjustment circuit (8) adjusting total composite impedance of said at least two transmitting/receiving antennas and said radio unit.

4. The portable radio equipment according to claim 3, wherein said impedance transformation circuit and said impedance adjustment circuit include variable capacitance diodes (C1-C9).

5. The portable radio equipment according to claim 1, further comprising:
a reception strength detector (12, 13) detecting received field strength of each of said at least two transmitting/receiving antennas;
a comparator (14) comparing the received field strength detected by said reception strength detector with the weighting of the antenna given by said power distributor; and
a control circuit (10) controlling the weighting by said power distributor based on the comparison output of said comparator, to optimize a ratio of the power being fed to the respective antennas.

6. The portable radio equipment according to claim 4, wherein
said power distributor includes
an impedance transformation circuit (6, 7, 11) controlling impedance of said at least two transmitting/receiving antennas to change the weighting of a distribution ratio of the power being fed to the respective antennas, and
an impedance adjustment circuit (8) adjusting total composite impedance of said at least two transmitting/receiving antennas and said radio unit.

7. The portable radio equipment according to claim 6, wherein said impedance transformation circuit and said impedance adjustment circuit include variable capacitance diodes (C1-C9).

8. The portable radio equipment according to claim 1, wherein said at least two transmitting/receiving antennas are placed orthogonal to each other.

9. The portable radio equipment according to claim 1, wherein one of said at least two transmitting/receiving antennas is a whip antenna, and the rest of said antennas includes a meander antenna that is folded to meander so as to reduce the total length.
